# EUROPEAN PATENT SPECIFICATION

(11) **EP 0 839 078 B1**
(45) Date of publication and mention of the grant of the patent: **19.09.2001**
(21) Application number: 96924997.8
(22) Date of filing: 18.07.1996
(51) Int. Cl.: B22D 23/00, B22F 9/08, C22C 28/00, H01L 23/36, H01L 23/373

(54) **Method of manufacturing Si-Al alloys for electronic packaging**
Verfahren zur Herstellung von Si-Al Legierungen zur Verpackung von electronischen Bauteilen
Procédé de fabrication d'une alliage de Al-Si utilisé dans l'encapsulation de composants électroniques.

(30) Priority: 19.07.1995 GB 9514777
(43) Date of publication of application: 06.05.1998
(73) Proprietor: OSPREY METALS LIMITED, Neath, West Glamorgan, SA11 1NJ (GB)
(72) Inventor: LEATHAM, Alan, George, Swansea SA3 3JY (GB); OGILVY, Andrew, Josef, Widawski, Port Talbot, West Glamorgan SA12 9YL (GB); ELIAS, Luis, Neath SA11 3AL (GB)
(74) Representative: Wilson, Nicholas Martin
(86) International application number: PCT/GB96/01730
(87) International publication number: WO 97/03775

(56) References cited:
- EP-A- 0 183 016
- EP-A- 0 411 577
- EP-A- 0 592 665
- WO-A-92/01525
- WO-A-94/11138
- DATABASE WPI Week 9624 Derwent Publications Ltd., London, GB; AN 96-236445 XP002018314 & JP,A,08 092 683 (SUMITOMO ELECTRIC IND. LTD.) , 9 April 1996

## Description

This invention relates to a method of producing an aluminium silicon alloy deposit having a relatively low thermal expansion coefficient and a relatively high thermal expansion coefficient.

Electronic packages provide the medium for electrical interconnections as well as the mechanical support of delicate electronic circuitry. The most basic, (zeroeth level), of electronic packaging is generally considered to be the semi-conductor chip, (Integrated Circuit), which houses logic gates, transistors and gate-to-gate interconnections which are formed directly on the chip. The chip itself is made from a thin slice or wafer of crystalline semi-conductor material such as silicon or gallium arsenide.

The packaging of the chip or set of chips in a functional and protective chip carrier is the next level of electronic packaging. Chip carriers can house a semi-conductor device or simply act as a substrate to which a semi-conductor is attached. Chip carriers can range from single-chip carriers to more sophisticated multi-chip modules which contain many individual chips. Silicon is the most widely used semi-conductor in single and multi-chip modules; gallium arsenide is used in high frequency applications such as microwave integrated circuits.

The term "level of integration" describes the number of microcircuit components placed on a chip and is thus the representation of its complexity and sophistication. The electronic industry trend has been to increase the electrical circuitry on the chip, i.e. increase the level of integration, while reducing the physical size of the chips. A result of increasing the level of integration is increased power densities and consequently a higher heat flux to be dissipated from the chip surface area. Consequently, materials with good thermal conductivity are required to meet the thermal management demands of increasing levels of integration.

The development of stresses at the chip to chip carrier interfaces, interconnections and solder joints due to thermal cycling is a prime concern in electronic packaging. Therefore the coefficient of thermal expansion, CTE, of electronic packaging materials is a particularly important material parameter. A close match between the CTEs of chip semi-conductor materials and chip carrier materials reduces the development of stresses which can lead to failure of electronic circuitry. Semi-conductor materials have low CTEs, for example, silicon has a CTE in the range 2.3-4.3ppm/°C and gallium arsenide has a CTE close to 6ppm/°C.

Pure aluminium and conventional aluminium alloys have been popular as electronic packaging materials for the dissipation of heat due to their high thermal conductivities in the range 200-235W/m°K. However, with the higher levels of integration used in multi-chip modules and microwave integrated circuits there are demands that cannot be satisfied by aluminium packages. Namely, the thermal expansion mismatch induced by the high CTEs of these materials which are in the range 22-24ppm/°C.

Other materials such as an Fe-29Ni-17Co alloy, also known as KOVAR (a Registered Trade Mark of The Carpenter Technology Corporation), with a CTE of 5.8ppm/°C reduce the thermal expansion mismatch with semi-conductor materials. However, with a thermal conductivity of 15-17W/m°K, Kovar is not the optimum material for the efficient thermal management. Low expansion refractory metals such as molybdenum and tungsten also have low thermal conductivities compared to aluminium. However, when mixed with copper to form W-Cu and Mo-Cu mixtures by powder metallurgy or by co-rolling, composite materials are derived that offer alternatives with higher thermal conductivities, albeit at a considerable weight penalty.

Weight considerations are particularly important in avionics and space applications. One method of producing lightweight electronic packaging materials with high thermal conductivities and low CTEs is via aluminium metal matrix composites (JOM, July 1992, p.24-28). Silicon carbide particulate is a common ceramic reinforcement choice due to its low coefficient of thermal expansion and high thermal conductivity values, good availability, and low cost, compared to other ceramic particuiates such as aluminium nitride. However, silicon carbide loadings in the range 65-75 vol% are required to obtain aluminium metal matrix composites with the low CTEs required for electronic packaging.

Methods for the manufacture of Al/SiC metal matrix composites can be classified as follows:
(i) liquid state processes in which the ceramic particulate is added to the molten matrix alloy, agitated to prevent SiC settling due to density differences, and cast to shape. However, this method is limited to SiC levels up to 30 vol%, because of problems with fluidity, and to certain aluminium alloy matrices which do not generate excessive aluminium carbide which is detrimental to mechanical properties and corrosion resistance.
(ii) solid state processes in which the matrix alloy is blended with ceramic particulate and pressed. In a practical sense these processes are limited to SiC reinforcements of approximately 60 vol% placing a limit on the CTE reduction available.
(iii) infiltration processes in which a green SiC compact is infiltrated with the molten matrix alloy. Very high SiC particle loadings can be achieved by infiltration processes (up to 75 vol%). Since the SiC-Al is non-wetting, infiltration is assisted using pressure infiltration or by conditioning the SiC particle surfaces to assist infiltration by capillary action. Whilst successful in achieving the SiC loading required for CTE matching with semi-conductor materials, the metal matrix composites are extremely difficult to machine. In addition, because of the multi-modal distribution of SiC particle sizes required to form the green compacts, the MMC is also difficult to metallize, to join, and can be prone to gas leakage at the high vacuums required for certain applications, e.g. helium leakage in satellite applications.
(iv) another route is spray forming, in which an aluminium-based alloy is melted and inert gas atomized and ceramic particulate is injected into the metal spray which co-deposits to form a metal matrix composite. However, it is not possible to introduce the required high loading of SiC (65-75 vol%) by this method. Such attempts have resulted in excessive porosity, particle clumping, and poor SiC loading reproducibility.

Another method for the production of aluminium alloys with a low coefficient of expansion is spray forming of hypereutectic aluminium-silicon alloys in which silicon acts as the reinforcing phase. Instead of introducing an exogeneous reinforcing ceramic phase or phases in the form of particulate or fibres, the reinforcing phase, silicon, is formed 'in-situ' by nucleation and growth from the liquid during solidification of the spray formed deposit. The advantage of this method is that the endogeneous reinforcing phase, silicon, is in perfect atomic contact with the aluminium matrix because the solid-state phases which constitute the alloy are derived from the same source, namely, the alloy in the liquid state. We have spray formed Al-Si alloys with silicon contents up to 50wt%. For example, we published a paper in the Second International Conference on Spray Forming in 1993 relating to such alloys where the main objective was to produce Al-Si alloys up to 50wt% for thixoforging, (i.e. forging in the semi-solid state to form structural wear-resistant products). However, it was found that it was not possible to form materials containing more than 35% silicon.

In EP-A-411577, there is disclosed a method of producing aluminium based alloys containing silicon where aluminium silicon alloys with up to 15 wt% Si are melted and fine silicon powder, preferably not more than 10µm mean particle size, is injected as particulate to produce spray formed deposits with total silicon contents up to 55wt%.

According to the first aspect of that invention, "silicon which is soluble in aluminium is deliberately sprayed in the form of solid particles and mixed into the aluminium alloy. Thus it is possible to produce an aluminium based alloy having a high content of silicon without increasing the melting temperature of the aluminium alloy." An example given was the preparation, melting and spraying of an aluminium alloy containing 15wt% silicon and the simultaneous deposition of silicon particles of 3µm mean particle size in amounts that would result in total silicon contents of 35wt%, 45wt% and 55wt%. The pouring temperature of the Al-15wt% Si alloy was quoted as 650°C.

We have found that the injection of fine particulate at such high volume fractions leads to:
(a) inhomogeneous distribution of the injected phase in the matrix,
(b) excessive porosity,
(c) high oxide content (because of the use of fine powder which has a large surface area), and
(d) low yields (because the fine particulate is carried away with the atomizing gas).

Accordingly, we believe such a method is impracticable.

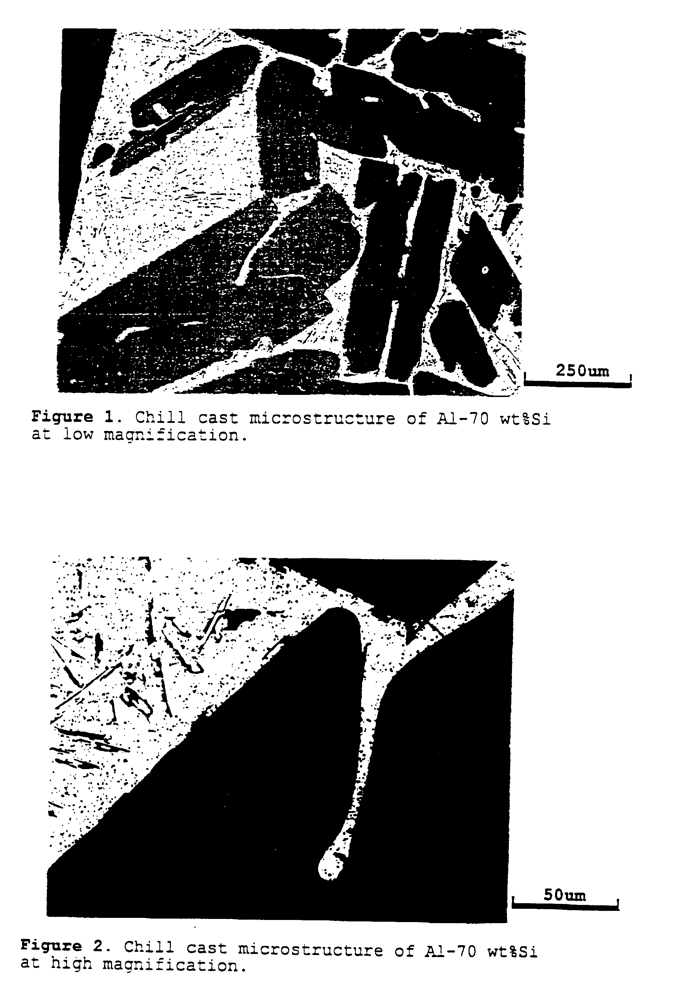

It is known that silicon-aluminium alloys can be produced by melting and casting, see for example, the German article "Gefuge und thermische Volumenänderungen von Al-Si-Legierungen" of Chanyuang Gan and Erhard Hornbogen. However, in the compositional range of interest (51-90wt%) the as-cast microstructure is characterized by mainly large, discrete, faceted, high aspect ratio primary silicon crystals which impair mechanical properties and machinability. For example, in Figures 1 and 2 of this application there is shown the microstructure of chill case A170%Si. Primary silicon crystals appear black against the light grey Al-Si eutectic constituent. The primary silicon particle size, which appear as single acicular crystals, is of the order of millimetres which results in a very anisotropic microstructure. This makes it quite unsuitable for the application to electronic packaging. For example, the plates which go to make up electronic packages are typically 1-5mm thick, with a chill cast material it would be possible to have one single silicon crystal passing through the whole plate thickness. This would make the material extremely difficult to machine to fine surface finishes required for metallization, because the silicon crystal would be susceptible to fracture in a single direction along a preferred crystallographic plane. In addition, because of the large silicon crystal size, the local CTE and thermal conductivity of the material may vary widely depending upon whether aluminium or silicon is in contact with the chip or chip carrier. It is generally considered that these alloys have no engineering application and are only used as master-alloys for liquid metal processing industries or steel deoxidation.

In accordance with our invention, we are proposing processing using a silicon-based alloy by inert gas atomization to form either a sprayformed deposit in accordance with claim 1.

A coherent spray formed deposit would preferably be hot isostatically pressed at a temperature above solidus to produce a product of substantially 100% density.

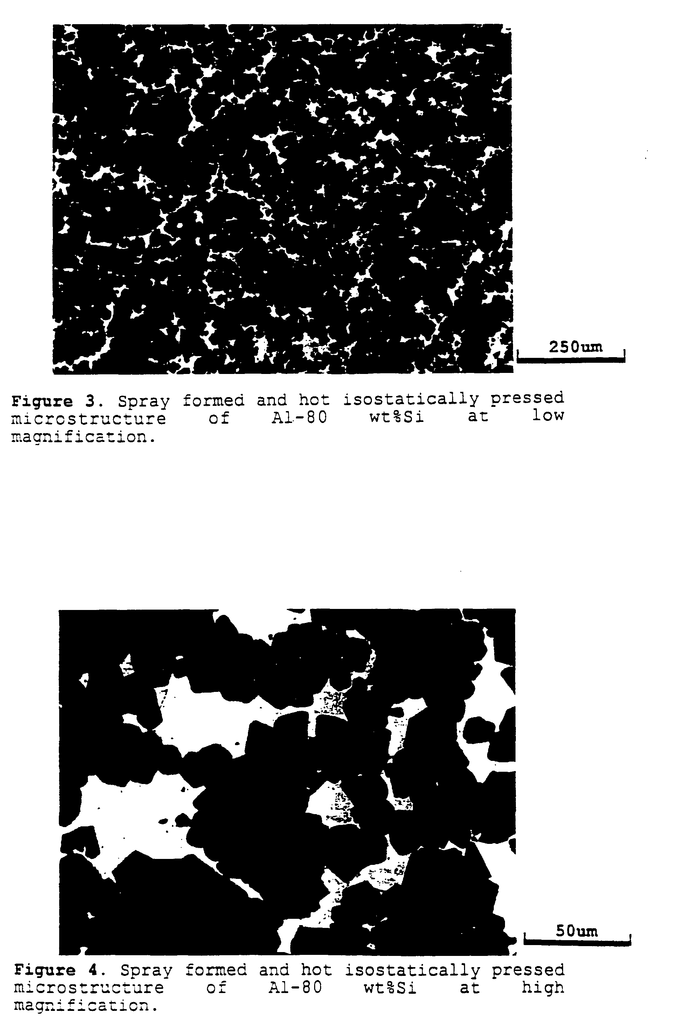

With the product of the invention, any fracture path would be tortuous rather than in a single plane. Moreover, by 'fine' we mean having silicon precipitate size less than 200 micron in the as-sprayed condition. For example, the preferred precipitate size in the as-sprayed condition is less than 100 micron. For the electrical packaging applications, it is preferred that the silicon content be greater than 65%. Figures 3 and 4 illustrate spray formed and hot isostatically pressed A180%Si, the dark grey constituent is silicon and the white constituent is aluminium. The substantially continuous phase of the silicon can be clearly seen.

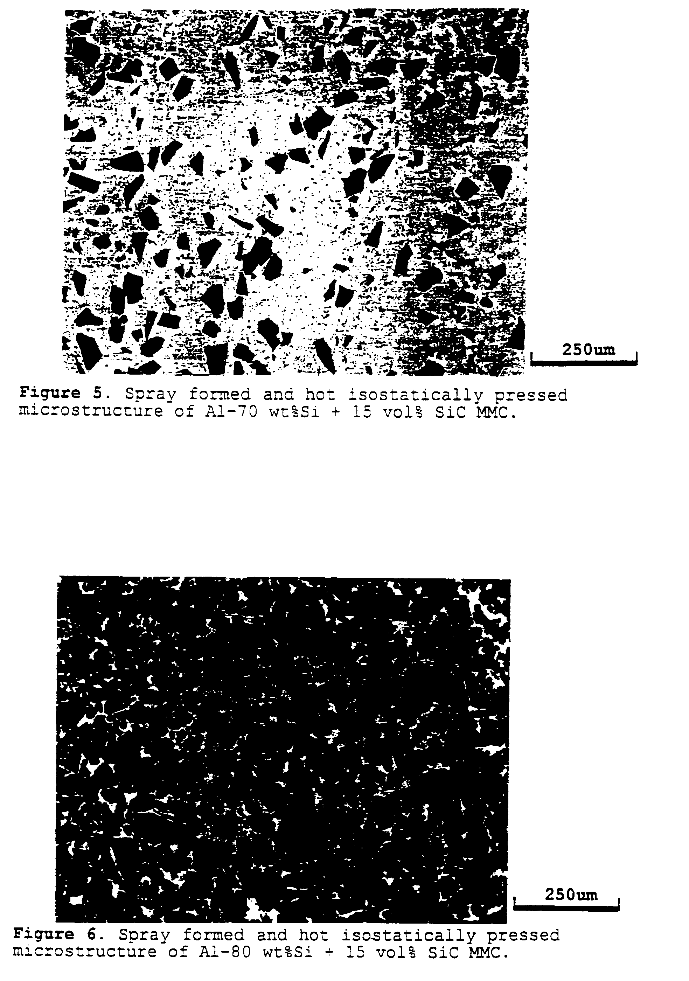

If desired, ceramic particles may be introduced into the atomizing spray. Figures 5 and 6 illustrate spray formed and hipped Al-70wt%Si and Al-80wt%Si with approximately 15wt% addition of 9µm SiC, the white constituent is aluminium, the light grey constituent is silicon, and the darker constituent is silicon carbide particulate. The ceramic particles may be injected into the spray or, when making powder, may simply be added to the powder material.

The method may comprise the further steps of hot isostatically pressing the material. This may be in the semi-solid condition, with or without encapsulation.

If the alloy material includes ceramic particulate additions, such as silicon carbide, up to 35vol% the metal matrix composite material may be encapsulated, evacuated, and hot isostatically pressed in the semi-solid condition.

The other alloy additions are deliberately added and exclude trace elements. The additions may include:
Magnesium - up to 2wt% - for refining the silicon phase.
Copper - up to 5wt% - forming a tertiary phase with a low coefficient of thermal expansion.
Iron - up to 8wt% - forming a tertiary phase with a low coefficient of thermal expansion.
Zirconium - up to 0.5wt% - for strengthening the aluminium matrix.

The additions may also include any alloy addition conventionally added to aluminium silicon alloys.

If desired, the alloy material may contain ceramic particulate, such as SiC up to 35vol%, but not in such large volumes as to render machinability and metallization of the material difficult. Suitably, alloys or MMCs in accordance with the invention have a coefficient of thermal expansion in the range 4.5-11ppm/°K and thermal conductivity greater than 100W/m°K. The maximum value of thermal conductivity that could be achieved would depend upon the reinforcing particulate, e.g. aluminium-nitride or diamond.

The method may be used to produce a microelectronic packaging material.

The alloy material may be semi-solid processed into a packaging component of desired configuration and/or may be machined. The invention is also applicable in applications where it is required to match thermal coefficients of another material and/or where one needs light weight and/or where one needs light weight and have rapidly moving parts of different coefficients of expansion and/or low thermal conductivity.

The innovative distinctions of the present invention stem from the fact that as a result of the manufacturing method the main constituent is silicon as a substantially continuous phase with aluminium as the alloying element. By atomizing the silicon alloy, silicon crystal growth begins during atomized droplet flight and, in the deposit, a large number of nucleative sites are created which grow and impinge into one another to form a network structure in which silicon crystals are randomly oriented and not discrete and highly orientated as in a cast structure and therefore present a substantially continuous phase making the deposit structurally coherent and capable of being machined to fine surface finishes.

Advantages of the so produced alloy materials are that they are machinable with conventional carbide tools, are weldable, brazable and coatable with materials such as gold.

Preliminary data for two types of novel metal matrix composites targeted at Microwave Integrated

Circuits (MIC) and Multichip Modules (MCM) respectively, are presented in Table 1 below. Tables 2 and 3 provide a selective comparison between the alloy materials of the present invention and a wide range of semi-conductor and other materials used in the electronics industry. These details have been published on 17th. November, 1995 under European Community Project No. BRE2-CT2-0146.

**TABLE 1:**

| **Selected Properties of Novel MMC Electronies Packaging Materials** | | | |
|---|---|---|---|
| PROPERTY | | MIC Packaging Materials | MCM Packaging Materials |
| Coefficient of thermal expansion | ppm/K | Specified in range 6.5-7.5 ±0.5ppm/K 0-500°C | Specified in range 4.5-6.0 ±0.5ppm/K 0-500°C |
| Thermal conductivity | Wm⁻¹K⁻¹ | 120-140 | 110-130 |
| Specific heat | Jkg⁻¹K⁻¹ | ∼750 | ∼750 |
| Ultimate tensile strength | MPa | ∼130 | ∼130 |
| Young's modulus | GPa | 140 (predicted) | 140 (predicted) |
| Density | gm/cc | 2.5 | 2.4 |
| Porosity | | <0.1 % not connected | <0.1 % not connected |
| Surface resistivity | *µ*Ω.cm | 80-150 | 200-1600 |
| Proven machining methods | | PCD: *Negligible wear* Carbide: *Some wear* EDM. Laser (<lmm) | PCD: *Negligible wear* EDM. Laser (<lmm) |

**TABLE 2:**

| **Selected Properties of Electronic Materials, Substrates and Packaging** | | | | |
|---|---|---|---|---|
| **Material** | **Thermal Conductivity Wm**^{**-1**}**K**^{**-1**} | **Thermal Expansion 10**^{**-1**}**K**^{**-1**} | **Density g/cc** | **Composition** |
| GaAs | 42 | 6.5 | 5.3 | GaAs |
| Si | 84 | 3.0 | 2.33 | Si |
| Alumina | 33 | 6.7 | 3.8 | Al₂O₃ |
| Aluminium nitride | 165 | 5.3 | 3.3 | AlN |
| Beryllia | 260 | 7.6 | 2.9 | BeO |
| Al-SiC MMCs | 160 (typical) | 7.0 | 3.0 | Al-70SiC (typial) |
| Aluminium | 201 | 23.2 | 2.7 | Al |
| Copper-tungsten | 160 | 7.6 | 17 | 80W-20Cu (typical) |
| Titanium | 22 | 9.5 | 4.5 | Ti |
| Kovar | 16.7 | 6 | 8.2 | 54Fe-29Ni-17Co |
| Copper | 385 | 16.1 | 8.9 | Cu |
| Novel MMC for MIC packaging | 130 | 6.8 | 2.5 | Al-Si-(SiC) |
| Novel MMC for MCM (Si) packaging | 110 | 4.8 | 2.5 | Al-Si-(SiC) |

**TABLE3:**

| **Comparison Between Novel MMCs and Other Current Packaging Materials** | | | | | | | |
|---|---|---|---|---|---|---|---|
| **Characteristic** | **Novel MMCs** | **Current MMCs** | **Kovar** | **Ti** | **Cu-W** | **Al**_{**2**}**O**_{**3**} | **AlN** |
| Expansion match to GaAs | Yes | Yes | Yes | Poor | Yes | Yes | Yes |
| Expansion match to silicon | Near | No | Near | No | No | No | Near |
| Thermal conductivity | High | High | Very low | Very low | High | Low | High |
| Machinability | Good by all conventional methods | Poor -diamond and EDM only | Good by all conventional methods | Good by all conventional methods | Reasonaole | Poor- Diamond only | Poor- Diamond only |
| Density | Low | Low | High | Medium | Very high | Medium | Low |
| Plating | Medium | Difficult | Easy | Difficult | Difficult | Difficult | Difficult |
| Cost | Medium | Medium | Medium | High | High | Low | High |

There are now described four examples of suitable alloy compositions each of which may be spray formed in accordance with the disclosure in our European Patent No. 0225732B, the contents of which are incorporated herein by reference. The spray conditions are suitably:
Atomizing gas - Nitrogen
Gas to Metal ratio 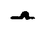 4m³/kg
Spray Distance - 700mm

The billet size is suitably 10kg of 150mm diameter.

### Example 1

80wt%Si
20wt%Al.

The CTE of this alloy is 4.8ppm/°C and the thermal conductivity at 120W/m°K is slightly lower than Example 2, but the material can be more easily machined by component manufacturers.

### Example 2

70wt%Si
30wt%Al with 15 vol% addition of SiC.

This has a CTE of 6.22ppm/°C and thermal conductivity of 150W/m°K.

### Example 3

70wt%Si
30wt%Al
CTE of 6.8 ppm/°C
Thermal conductivity of 140W/m°K.

### Example 4

55wt%Si
45wt%Al
CTE of 10.5ppm/°C
Youngs Modules of 115GPa
Yield Stress of 140 MPa.

## Claims

1. A method of producing an aluminium silicon alloy deposit comprising the steps of:
melting an aluminium silicon alloy containing between 51% and 90% Si;
inert gas atomizing such alloy into a spray in which silicon crystal growth begins during atomized droplet flight; and
collecting the spray as a coherent deposit in which a large number of silicon nucleation sites are created which grow and impinge into one another to form a substantially continuous phase of silicon made up of fine, randomly oriented silicon crystals,
the coefficient of thermal expansion of the coherent deposit being in the range 4.5-1 1ppm/°K; and
the thermal conductivity of the coherent deposit being greater than 100W/M°K.

2. A method according to claim 1, comprising melting a silicon alloy containing greater than 65wt%Si.

3. A method according to claim 1 or 2, wherein the silicon precipitate size is less than 200 micron.

4. A method according to claim 3, wherein the silicon precipitate size is less than 100 micron.

5. A method according to any one of claims 1 to 4, comprising deliberately adding alloy additions selected from 2wt% Magnesium, up to 5wt% Copper, up to 8wt% Iron, up to 0.5wt% Zirconium.

6. A method according to any one of claim 1 to 5, comprising the further step of introducing ceramic particles.

7. A method according to claim 6, wherein the ceramic particles are silicon carbide particles.

8. A method according to claim 7 or 6, wherein the ceramic particles are introduced by injection into the spray during spray deposition of the silicon alloy.

## Patentansprüche

1. Verfahren zur Herstellung einer Abscheidung aus einer Aluminium-Silicium-Legierung mit den Stufen:
Aufschmelzen einer Aluminium-Silicium-Legierung, die zwischen 51 % und 90 % Si enthält;
Inengas-Atomisierung einer solchen Legierung zu einem Spray, in dem ein Silicium-Kristall-Wachstum während des Fluges der atomisierten Tröpfchen einsetzt; und
Auffangen des Sprays in Form einer kohärenten Abscheidung, in der eine große Anzahl von Silicium-Keimbildungs-Zentren erzeugt wird, die wachsen und aufeinander auftreffen, unter Erzeugung einer praktisch kontinuierlichen Phase von Silicium, die aus feinen, willkürlich orientierten Silicium-Kristallen gebildet wird, wobei
der thermische Expansions-Koeffizient der kohärenten Abscheidung im Bereich von 4,5-11 ppm/°K liegt; und
die thermische Leitfähigkeit der kohärenten Abscheidung größer als 100 W/M°K ist.

2. Verfahren nach Anspruch 1, bei dem eine Silicium-Legierung aufgeschmolzen wird, die mehr als 65 Gew.-% Si enthält.

3. Verfahren nach Anspruch 1 oder 2, bei dem die Größe der Silicium-Fällung geringer als 200 Mikron ist.

4. Verfahren nach Anspruch 3, bei dem die Größe der Silicium-Fällung geringer als 100 Mikron ist.

5. Verfahren nach einem der Ansprüche 1 bis 4, bei dem bewußt Legierungs-Zugaben erfolgen, die ausgewählt sind aus 2 Gew.-% Magnesium, bis zu 5 Gew.-% Kupfer, bis zu 8 Gew.-% Eisen und bis zu 0,5 Gew.-% Zirkonium.

6. Verfahren nach einem der Ansprüche 1 bis 5, das die weitere Stufe der Einführung von keramischen Teilchen umfaßt.

7. Verfahren nach Anspruch 6, bei dem die keramischen Teilchen Siliciumcarbid-Teilchen sind.

8. Verfahren nach Anspruch 7 oder 6, bei dem die keramischen Teilchen durch Injektion in den Spray während der Spray-Abscheidung der Silicium-Legierung eingeführt werden.

## Revendications

1. Procédé de fabrication d'un dépôt d'alliage de silicium et d'aluminium comprenant les étapes consistant à :
fondre un alliage de silicium et d'aluminium contenant entre 51% et 90% Si ;
atomiser dans un gaz inerte un tel alliage sous forme d'un jet vaporisé dans lequel la croissance d'un cristal de silicium commence lors de la projection d'une gouttelette atomisée ; et
collecter le jet vaporisé sous forme d'un dépôt cohérent dans lequel un grand nombre de sites de formation de noyaux de silicium sont créés qui croissent et entrent en collision les uns dans les autres de façon à former une phase essentiellement continue de silicium fabriquée de fins cristaux de silicium, orientés au hasard,
le coefficient de dilatation thermique du dépôt cohérent étant situé dans la plage de 4,5-11ppm/°K ; et
la conductivité thermique du dépôt cohérent étant supérieure à 100W/m°K.

2. Procédé selon la revendication 1, comprenant la fusion d'un alliage de silicium contenant plus de 65% en poids de Si.

3. Procédé selon la revendication 1 ou 2, dans lequel la dimension de précipité du silicium est inférieure à 200 microns.

4. Procédé selon la revendication 3, dans lequel la dimension de précipité du silicium est inférieure à 100 microns.

5. Procédé selon l'une quelconque des revendications 1 à 4, comprenant l'addition volontaire d'additions d'alliage choisies allant de 2% en poids de magnésium, jusqu'à 5% en poids de cuivre, allant jusqu'à 8% en poids de fer, allant jusqu'à 0,5% en poids de zirconium.

6. Procédé selon l'une quelconque des revendications 1 à 5, comprenant l'étape complémentaire consistant à introduire des particules de céramique.

7. Procédé selon la revendication 6, dans lequel les particules de céramique sont des particules de carbure de silicium.

8. Procédé selon la revendication 6 ou 7, dans lequel les particules de céramique sont introduites par injection dans le jet vaporisé lors du dépôt par le jet vaporisé de l'alliage de silicium.
